(19) Europäisches Patentamt
European Patent Office
Office européen des brevets

(11) **EP 4 376 023 A1**

(12) **EUROPEAN PATENT APPLICATION**

(43) Date of publication:
**29.05.2024 Bulletin 2024/22**

(21) Application number: **23211162.5**

(22) Date of filing: **21.11.2023**

(51) International Patent Classification (IPC):
**G21B 1/23** $^{(2006.01)}$     **H01S 3/00** $^{(2006.01)}$

(52) Cooperative Patent Classification (CPC):
**G21B 1/23; H01S 5/005; H01S 5/0071**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.11.2022 US 202263427351 P**

(71) Applicant: **Focused Energy Inc.**
**Austin, TX 78758 (US)**

(72) Inventors:
• **JARROTT, Leonard Charles**
 **Austin, 78758 (US)**
• **DITMIRE, Todd**
 **Austin, 78758 (US)**
• **HANNASCH, Andrea J.**
 **Austin, 78758 (US)**

(74) Representative: **LifeTech IP**
**Spies & Behrndt Patentanwälte PartG mbB**
**Elsenheimerstraße 47a**
**80687 München (DE)**

(54) **IRRADIATION ASSEMBLY AND METHOD OF GENERATING A LASER BEAM FOR A LASER-BASED FUSION REACTION**

(57)     An irradiation assembly (100) for a laser-based fusion reaction is disclosed. The laser-based fusion reaction is an initiation of a fusion reaction in a fusion fuel pellet (10) by a laser beam (50). The irradiation assembly (100) comprises: an optical input (110) for the laser beam (50) originating from a laser source (60); a profile forming component (120); and at least one steering element (130). The laser beam (50) has an initial transverse phase distribution (51) and an initial transverse intensity profile (52). The profile forming component (120) is configured to shape the initial phase distribution (51) of the laser beam (50) so that the initial transverse intensity profile (52) is transformed into a final transverse profile (57) at the fusion fuel pellet (10). The at least one steering element (130) is configured to steer the laser beam (50) towards the profile forming component (120) or towards the fusion fuel pellet (10) to trigger the fusion reaction in the fusion fuel pellet (10) by the laser beam (50). The final transverse intensity profile (57) has a Gaussian-like profile when arriving at the fusion fuel pellet (10).

Fig. 1

**Description**

The present invention relates to an irradiation assembly for a laser-based fusion reaction, to a method for triggering a laser-based fusion reaction in a fusion fuel pellet, and, in particular, to a spatial profile shaping of laser beams for optimizing laser-based fusion reactions.

BACKGROUND

In inertial confinement fusion (ICF), a spherical capsule of frozen Deuterium-Tritium (DT) is irradiated by a spherically symmetric set of extremely intense laser beams. The laser beams are so intense that they cause the outer surface of the DT capsule to explode radially outward. By virtue of Newton's Third Law, this causes the remainder of the DT capsule to be pushed inward. This inward motion compresses and heats the DT mixture and eventually causes the Deuterium and Tritium atoms to fuse together, releasing enormous amounts of energy that can be used to power an electrical grid. For this process to be successful, the lasers should irradiate the target as uniformly as possible to prevent hydrodynamic instabilities and the maximum amount of laser energy needs to be deposited throughout the compression of the fusion fuel. To date, experiments have been unsuccessful in realizing fusion in a power plant setting, largely due to the lack of irradiation uniformity and laser energy coupling efficiency.

Over the last years, there has been extensive work trying to optimize the laser irradiation configuration in ICF experiments. From a purely physics-based standpoint, the uniformity of the laser irradiation scales with the square root of the number of laser beams, implying that one should use as many lasers beams as possible to optimize the probability of achieving fusion. Unfortunately, high power lasers are extremely expensive. There are several high-power laser facilities with varying number of laser beams. None of these facilities have been successful in achieving fusion at a threshold necessary to power an electrical grid.

Currently, inertial confinement fusion experiments need large laser beam spot radii in order to create a uniform irradiation pattern on the DT capsule in order to minimize hydrodynamic instabilities in the compression of the capsule. Simultaneously, inertial confinement fusion experiments require small laser beam spot radii in order to maximize laser energy coupling to the DT capsule, to maintain large amounts of laser power on the target as it compresses to smaller radius, and minimize laser-matter instabilities. These mutually exclusive requirements have limited the success of inertial confinement fusion experiments to date.

Therefore, there is a demand for further irradiation assemblies that are able to trigger a laser-based fusion reaction.

SUMMARY OF THE INVENTION

At least some of the above-mentioned problems are solved by an irradiation assembly according to claim 1, an irradiation system according to claim 8, and a method for triggering a laser-based fusion reaction according to claim 11. The dependent claims refer to further advantageous realizations for the subject matters of the independent claims.

The present invention relates to an irradiation assembly for a laser-based fusion reaction. The laser-based fusion reaction is the initiation of a fusion reaction in a fusion fuel pellet by a laser beam. The irradiation assembly comprises:

- an optical input for a laser beam originating from a laser source, the laser beam having an initial transverse intensity profile and an initial transverse phase distribution;
- a profile forming component configured to shape the initial phase distribution of the laser beam so that the initial transverse intensity profile is transformed into the final transverse intensity profile at the fusion fuel pellet; and
- at least one steering element configured to steer the laser beam towards the profile forming component or towards the fusion fuel pellet to trigger the fusion reaction in the fusion fuel pellet by the laser beam.

The final transverse intensity profile has a Gaussian-like profile when arriving at the fusion fuel pellet. For example, the profile forming component may be configured to shape the phase distribution accordingly to achieve this result. In addition, the Gaussian-like profile may have an optimum size (e.g. width) and beam spacing. A Gaussian-like profile may be defined by having a shape of the intensity distribution that can be approximated by a Gaussian function, i.e. defining the so-called "bell curve".

The transverse intensity profile can be defined as the intensity distribution in a cross section of the laser beam (perpendicular to the propagation direction). Accordingly, it is a spatial profile, because it refers to the spatial variations of the intensity (not the variations in time or longitudinal distribution). The phase distribution refers to the relative optical phase between neighboring portions of the laser (e.g. in a given cross section of the laser beam) and affects how the transverse intensity distribution evolves as the laser beam propagates. Accordingly, it is also a spatial profile because it refers to spatial variations in the phase (not variations in time). For example, a flat phase front means that all points along a transverse cross section of laser have the same phase.

The final Gaussian-like transverse intensity profile can be understood as a normal distribution for the intensity in a cross section of the laser beam at the fusion fuel pellet. According to embodiment, the initial phase distribution is shaped so that a Gaussian-like transverse intensity profile will emerge at the fusion fuel pellet.

The concrete details for achieving a Gaussian-like profile depends strongly on the whole setup such as the propagation lengths between the optical elements, materials of the optical elements and others. A person skilled in the art will readily find the concrete adjustments needed for a particular setup to achieve this. The possible optical components that can be utilized for this are described in the following.

Optionally, the profile forming component includes at least one of the following:

- one or more deformable mirrors with a locally deformable reflection surface configured to shape the initial phase distribution of the laser beam;
- one or more phase plates with variable (e.g. not constant or changeable) thickness configured to shape the initial phase distribution of the laser beam;
- one or more dynamic phase modulators (e.g. deformable phase plates) configured to shape the initial phase distribution of the laser beam;
- one or more focusing lenses to focus the laser beam (e.g. towards the fusion pallet);
- one or more focusing mirrors to focus the laser beam (e.g. towards the fusion pallet).

Optionally, the one or more deformable mirrors include at least one actuator configured to locally shift or move the reflection surface. The deformable mirror reflects neighboring portions of the laser beam differently so that the optical path length travelled is different. Therefore, the deformable mirror modifies the relative phase locally along the surface upon reflection resulting effectively (e.g. due to interference) into steering of the wave front. The deformable mirror is configured to shape the initial phase distribution so that the initial transverse intensity profile is transformed into the final Gaussian-like intensity profile at the fusion fuel pellet. For this, the remaining travel time, further reflections or a focusing and other concrete parameters can be considered to end up with the desired profile ideally exactly at the surface of the fusion pallet. According to embodiments, the actuator(s) are configured to allow changes even during operation to make (in-time) adaptations in the transformed transverse profile. Therefore, it may be possible to make dynamic changes until the desired result of Gaussian-like profile is achieved.

Optionally, the one or more phase plates include a transparent substrate with a pattern of transparent layers formed on a surface of the substrate to provide a pattern of different optical distances for the laser beam upon passing through the phase plates. Therefore, the phase plate modifies the phase locally along the surface upon transmission resulting effectively into steering of the wave front. It may thus result into the same effect as the deformable mirrors, namely that the phase of the laser beam is not constant across the spatial profile, but it differs for different positions on a spatial cross section. The phase plate can be manufactured so that the changes (e.g. dynamically) to the initial phase distribution will result in a Gaussian-like intensity profile at the fusion fuel pellet.

According to embodiments, the dynamic phase modulator may include clear (transmissive) regions that are configured locally to modify the optical distances for the laser upon transmission. The optical distances may be changed by changing the index of refraction of the material by applying (local) pressure or an electro-magnetic field to the material. Again, according to embodiments, these changes may be performed even during operation to make (in-time) adaptations in the transformed transverse profile.

It is understood that the concrete realization of the deformable mirror and/or phase plates depend on various system parameters such as the laser wavelength, the shape and size of the beam, the initial phase and intensity distribution, the (optical) distance to the fusion fuel pellet for the different transverse portions in the laser beam and other parameters. However, for each system and following the above principles it is straightforward to find the concrete realization or solution for the deformable mirror and/or phase plates.

Optionally, the profile forming component is configured to generate a final Gaussian-like transverse intensity profile with a predetermined size that corresponds to or is smaller than the size of the fusion fuel pellet when hitting the fusion fuel pellet. The predetermined size may be determined by an optimization of the irradiation uniformity on the fusion fuel pellet. A Gaussian-like profile used in this manifestation may have improved irradiation uniformity than previously used flat top irradiation profiles. A Gaussian-like profile is any profile that resembles a transverse intensity profile that can be defined by a Gaussian function. A Gaussian function can be defined by an exponential function with an exponent given by the negative quadratic form in its argument. It can be one- or multi-dimensional and is defined in statistics as a normal distribution. It is characterized by expectation (or mean) value(s) which minimize the quadratic form, and the standard deviation or variance. Accordingly, Gaussian-like profiles have a peak at the center and decreasing intensity moving away from the central peak.

Optionally, the irradiation assembly further includes a laser amplifier for the laser source configured to amplify the laser beam with a near flattop spatial profile (e.g. prior to the profile forming component) and to provide the laser beam at the optical input. The flattop profiles can be modeled as higher-order Gaussian (or Super-Gaussian) distributions.

Optionally, the irradiation assembly includes a control device configured to optimize the final transverse intensity profile by controlling, e.g. during operation, the profile forming component to shape the initial phase distribution of the laser beam, and/or to control the at least one steering element to steer the laser beam. The feedback for this optimization can be given the success of the triggered fusion reaction. For example, as long as no fusion reaction has been triggered yet or the needed energy to start the fusion reaction is too high, the control device can change the controlling. Alternatively or additionally, before starting concrete fusion reactions, concrete measurements can be performed (e.g. replacing the fusion pellet by a measurement device) to measure the final transverse intensity profile. This may be performed for each laser beam separately.

Further embodiments relate to an irradiation system with multiple irradiation assemblies as described before. The multiple irradiation assemblies may be arranged to irradiate the fusion fuel pellet from different directions with respective laser beams.

Optionally, each irradiation assembly directs a laser beam onto a respective surface portion of the fusion fuel pellet, wherein the surface portions of multiple laser beams have some overlap with each other. In other words, a diameter of the laser beam when hitting the fusion fuel pellet may correspond to an optimum that is at most the diameter of the fusion fuel pellet itself. The diameter of the final Gaussian-like transverse profile (e.g. of each beam at the fusion fuel pellet) can be defined by the variance $\sigma$ of the Gaussian profile that best fits the distribution. Optionally, the diameter can be defined as a multiple of the variance (e.g. at least 2 $\sigma$, 3 $\sigma$ etc.). The diameter may also be defined by the width where the intensity has dropped by a particular amount (e.g. $1/e^2$). Alternatively or in addition, the overlap may also be defined by a certain percentage of the area (e.g. at most 10%, about 10%, about 20%, or more than 20%, or any other values).

Optionally, the fuel pellet is placed at the center of a target chamber that comprises multiple ports. The multiple irradiation assemblies may be arranged to provide multiple laser beams through at least one of the multiple ports (or all of the ports). An advantage to providing multiple laser beams through a single port is that the beam-to-beam power balance will improve. Since the Gaussian profile may provide comparably little overlap for the beams and since variations will occur from shot to shot (e.g. subsequent pulses of laser beam), at least some shots may otherwise transmit insufficient power to the fusion material. This effect can be mitigated by utilizing multiple beams for each port but is not necessary if the beam-to-beam power balance is sufficient.

Further embodiments relate to a method for triggering a laser-based fusion reaction in a fusion fuel pellet. The method comprises:

- providing a laser beam originating from a laser source with an initial transverse phase distribution and intensity profile;
- transforming the initial transverse intensity profile into a final transverse intensity profile at the pellet by shaping the initial phase distribution; and
- steering the laser beam towards the phase modulating component or towards the fuel pellet to trigger the fusion reaction by the laser beam.

The final transverse intensity profile is again adapted to become a Gaussian-like profile when arriving at the fuel pellet.

Optionally, the step of transforming the initial transverse spatial profile into the desired final transverse intensity profile (e.g. at the fusion fuel pellet) includes one or more of the following:

- reflecting the laser beam at a non-homogenous surface;
- refracting the laser beam by a focusing lens or an adaptive lens;
- adaptively shifting phases of the laser beam in a cross section of the laser beam.

According to embodiments, the steps of adaptively reflecting and/or refracting and/or shifting phases are performed on the initial laser beam to achieve the final Gaussian-like intensity profile when the laser beam hits the fuel pellet.

Therefore, embodiments overcome at least some of the problems of conventional devices by generating a novel laser beam spatial profile (transverse profile) for use in inertial confinement fusion facilities. The beam profile, generated according to embodiments, allows for smaller beam spot radii while maintaining a uniform irradiation pattern on the fuel capsule. It does not require "zooming", i.e. providing a technique where the laser diameter decreases on the fusion fuel pellet while it shrinks in size due to compression. According to embodiments, the diameter of the final Gaussian-like intensity profile can be smaller than the fusion fuel pellet diameter while keeping the non-uniformity low so that laser energy almost completely irradiates the target while it is imploding to smaller radius, removing the requirement for "zooming". The profile does not change while the fusion fuel pellet shrinks. Each pulse of the laser may be directed on new fusion fuel pellet. There may be small deviations in the laser pulses and/or the fusion fuel pellets. Embodiments provide all components needed to shape the initial phase and adjust the diameter of the final Gaussian-like intensity profile during operation (in-time).

Conventional irradiation assemblies utilize merely Super-Gaussian (flat) laser profiles which, however, require large beam spot radii. Large spot radii lead in turn to many deleterious effects. These effects include, inter alia, low laser energy coupling due to the laser radius being larger than the capsule radius, low laser energy coupling due to scattering of laser rays obliquely incident on the fusion capsule, and low energy coupling due to enhanced Cross Beam Energy Transport. Alternatively, when using small beam spot radii with Super-Gaussian beams, the irradiation non-uniformity is too large resulting in hydrodynamic instabilities that quench the fusion reaction. These drawbacks are overcome by embodiments when utilizing the Gaussian-like laser profile.

Embodiments provide the following advantages based on the beam profile formed as Gaussian-like beams:

- Gaussian-like beams produce a smoother irradiation pattern than the profiles currently being used by inertial confinement fusion experiments;
- smoother profile means one can use a smaller beam spot radius;
- smaller beam spot radius reduces many deleterious effects such as: scattering of laser rays that are obliquely incident on the capsule, scattering due to cross beam energy transfer, laser "blowby", where laser light blows directly by the capsule (fusion fuel pellet) because the laser radius is larger than the capsule radius;
- the Gaussian-like beams are produced by the beam transport to ensure that the Gaussian-like beam is available when it is needed;
- multiple beams per port can mitigate any beam-to-beam power imbalance.

BRIEF DESCRIPTION OF THE DRAWINGS

Various embodiments of the present invention will be described in the following by way of examples only, and with respect to the accompanying drawings, in which:

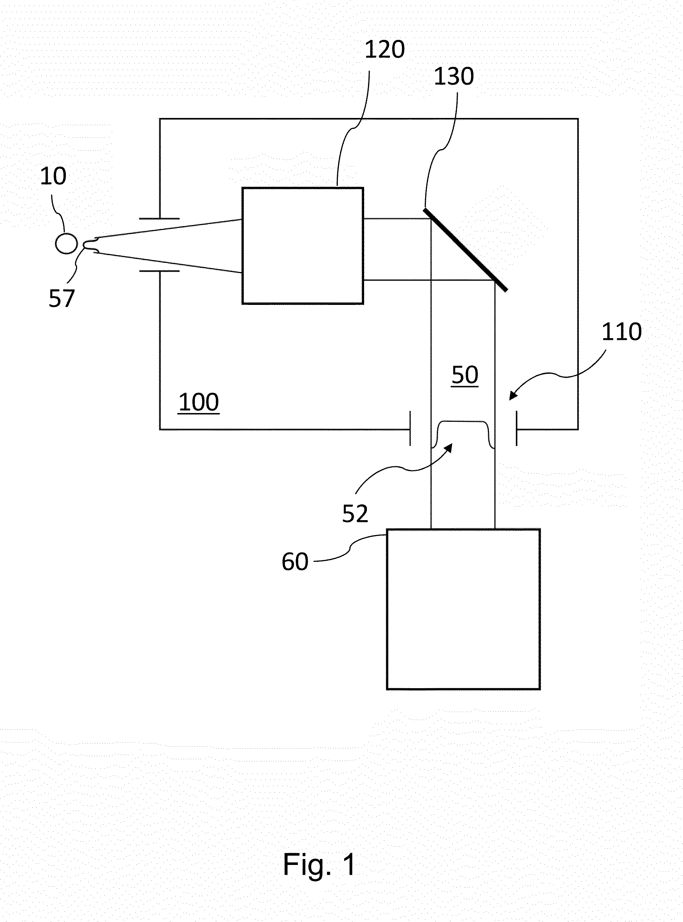

Fig. 1    depicts an irradiation assembly according to an embodiment of the present invention that comprises a laser source, optical input for a laser beam, steering component(s), profile forming component and fusion fuel pellet.

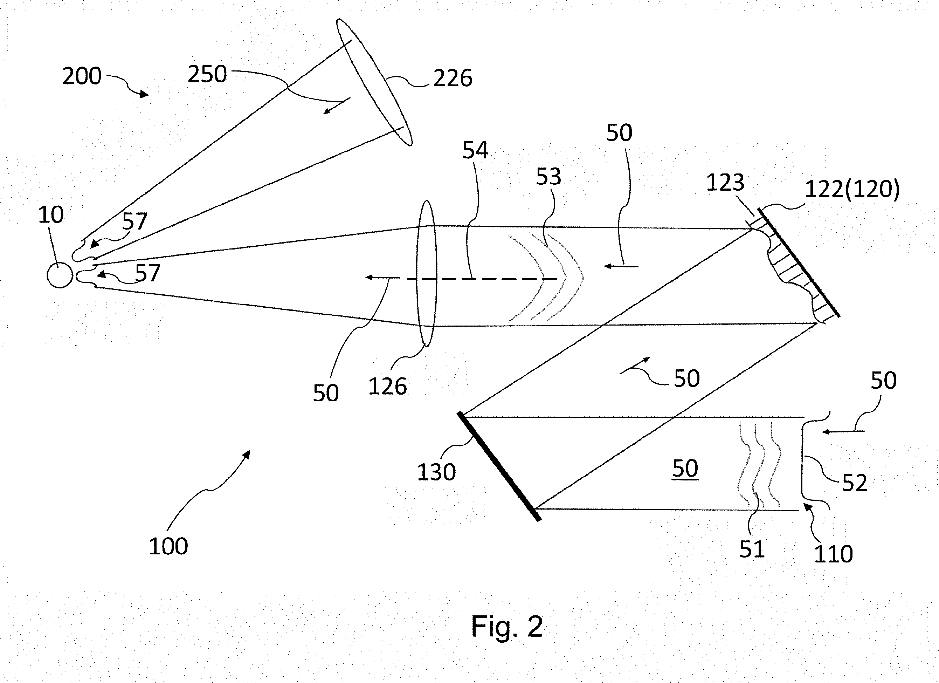

Fig. 2    depicts an irradiation assembly according to another embodiment with a profile forming component that comprises a single deformable mirror and focusing lens for transforming the initial transverse intensity profile into a final Gaussian-like transverse intensity profile at the fusion fuel pellet.

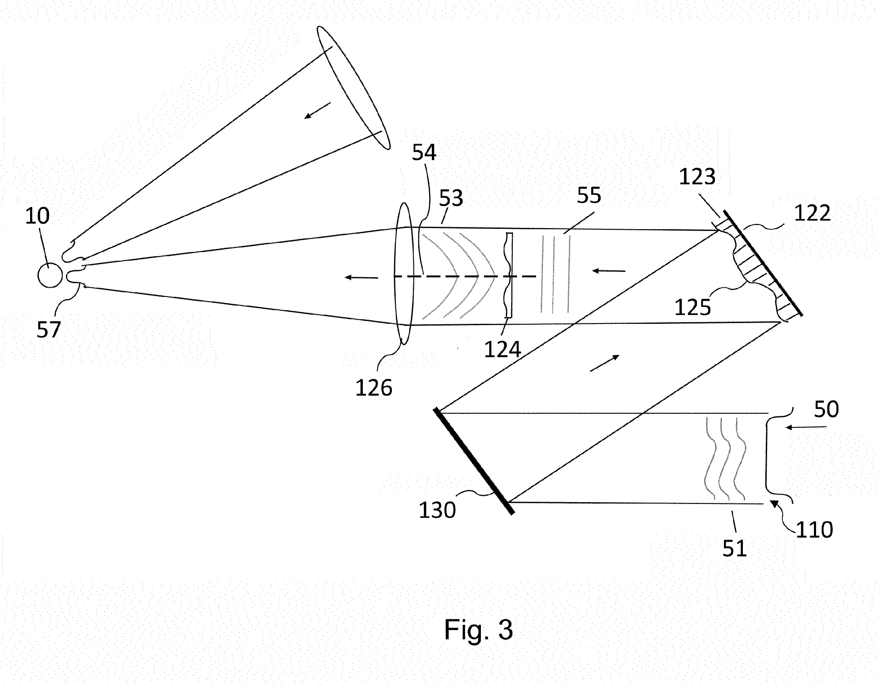

Fig. 3    depicts an irradiation assembly according to yet another embodiment with a profile forming component that comprises a deformable mirror, phase plate and focusing lens for transforming the initial transverse intensity profile into a final Gaussian-like transverse intensity profile at the fusion fuel pellet.

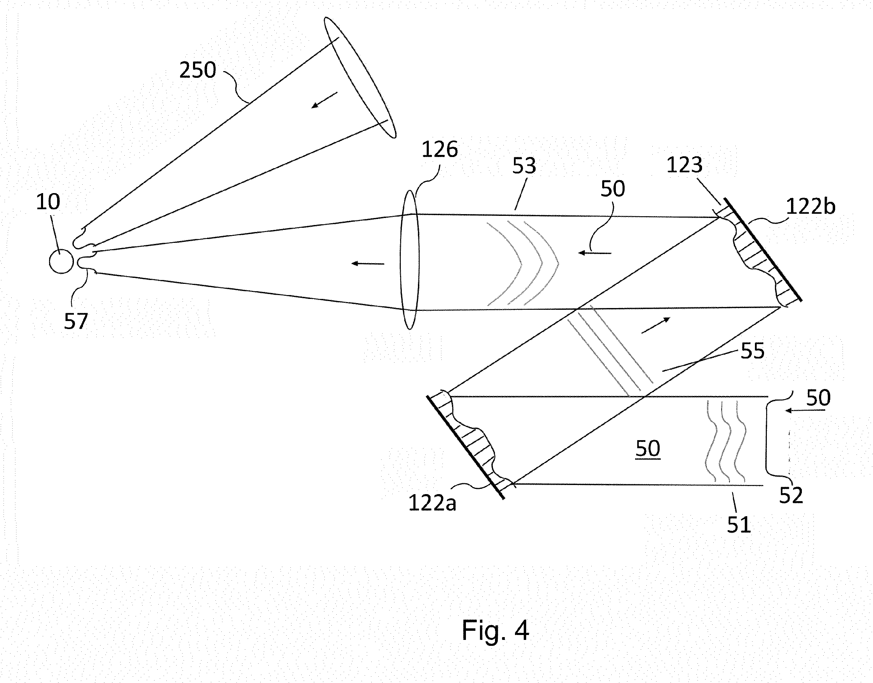

Fig. 4    depicts an irradiation assembly according to yet another embodiment with a profile forming component that comprises two deformable mirrors and a focusing lens for transforming the initial transverse intensity profile into a final Gaussian-like transverse intensity profile at the fusion fuel pellet.

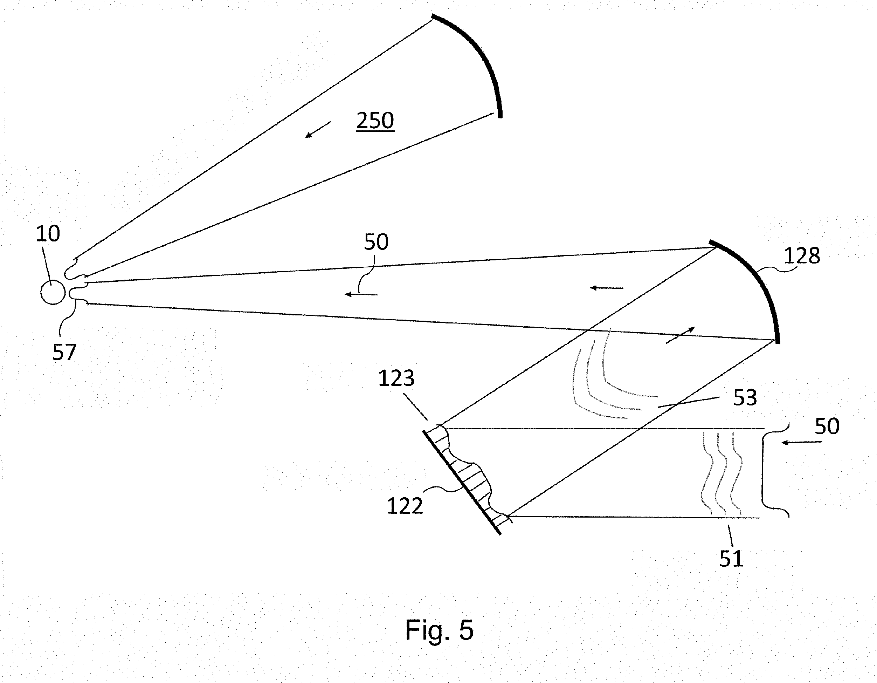

Fig. 5    depicts an irradiation assembly according to yet another embodiment with a profile forming component that comprises a single deformable mirror and a focusing mirror for transforming the initial transverse intensity profile into a final Gaussian-like transverse intensity profile at the fusion fuel pellet.

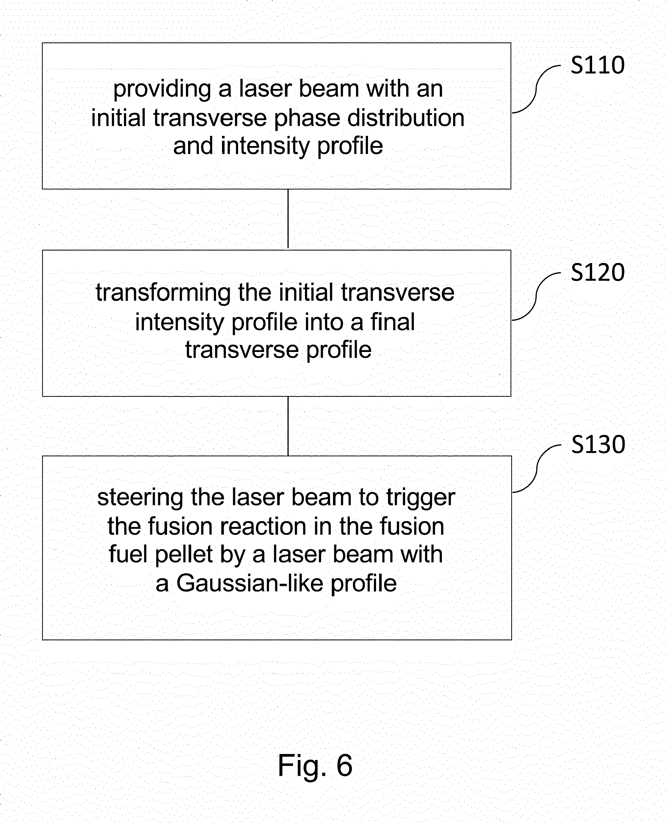

Fig. 6    shows a schematic flow chart for a method for triggering a laser-based fusion reaction in a fusion fuel pellet according to an embodiment of the present invention.

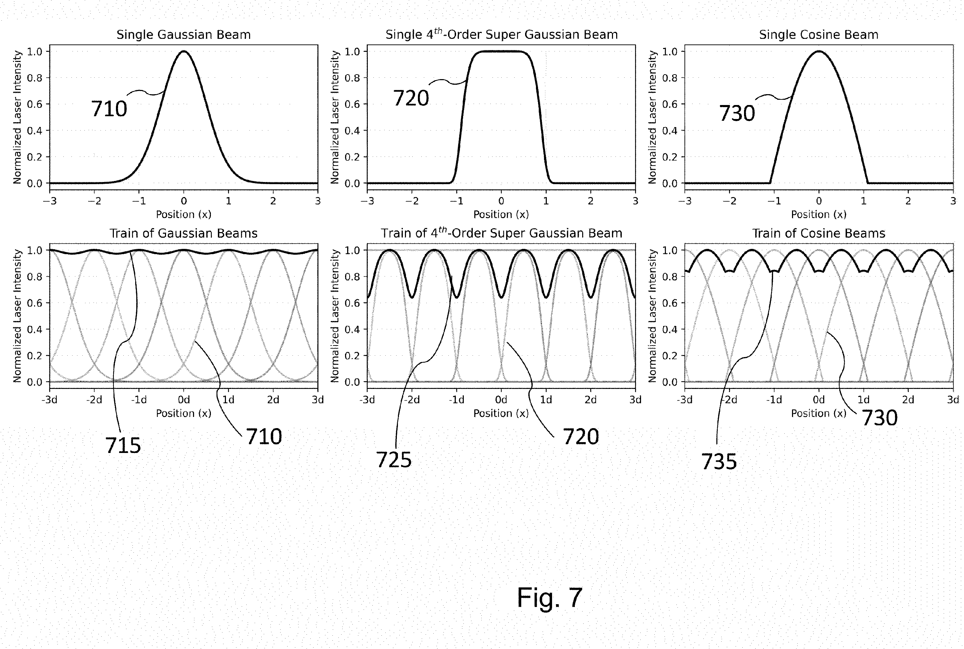

Fig. 7    shows (top left) a single Gaussian beam intensity profile according to an embodiment, peak intensity is normalized to one and (bottom left) train of Gaussian beams spaced a distance, d, apart from each other. The bold black curve shows the sum of the entire train of pulses, normalized to one. The same is shown for a $4^{th}$-order Super-Gaussian intensity profile (middle) and single cosine intensity profile (right).

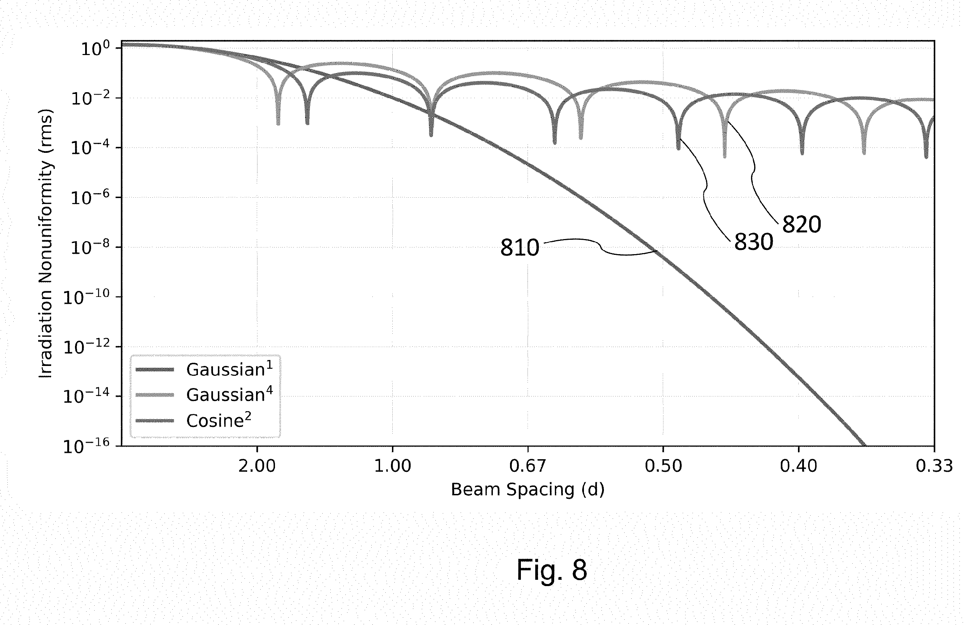

Fig. 8    shows the irradiation nonuniformity (rms) as a function of the periodic spacing distance, d, for a Gaussian profile (blue curve), $4^{th}$-order Super-Gaussian (orange curve) and a Cosine profile (green curve)

DETAILED DESCRIPTION

Various examples will now be described more fully with reference to the accompanying drawings in which some examples are illustrated.

Accordingly, while examples are capable of various modifications and alternative forms, the illustrative examples in the figures will herein be described in detail. It should be understood, however, that there is no intent to limit examples to the particular forms disclosed, but on the contrary, examples are to cover all modifications, equivalents, and alternatives falling within the scope of the disclosure. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing illustrative examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

**Fig. 1** shows an irradiation assembly 100 for a laser-based fusion reaction according to an embodiment of the present invention. The laser-based fusion reaction shall be triggered in a fusion fuel pellet 10 by irradiating a plurality of laser beams. Each of the laser beams can be generated by the depicted irradiation assembly 100, which includes an optical input 110, a profile forming component 120, and steering or focusing element(s) 130. Optionally, the fusion fuel pellet 10 is to be uniformly compressed, the focusing element 130 can be a steering optics, the optical input 110 is for the incoming laser beam from an amplifier with near-flattop intensity spatial profile.

The laser beam 50 is generated by a laser source 60 (or by an amplifier) and enters the irradiation assembly 100 through the optical input 110. Optionally, the laser source 60, which may possibly be a laser amplifier chain, can be part of the irradiation assembly 100. The steering or focusing element 130 is configured to steer the laser beam 50 received from the laser source 60 towards the profile forming component 120. Optionally, one or more further steering or focusing elements 130 may be arranged between the fusion fuel pellet 10 and the profile forming component 120.

The profile forming component 120 is configured to transform the initial transverse spatial intensity profile 52 of the laser beam into a final Gaussian-like intensity profile 57 at the fusion fuel pellet 10. The initial transverse spatial intensity profile 52 of the laser source 60 has for example a flat shape across the laser beam 50 whereas the final spatial intensity profile 57 which impinges on the fusion fuel pellet 10 has a Gaussian-like intensity profile. A Gaussian-like profile is not flat and has a distinct maximum in the center of the laser beam 50 with decreasing intensity further from the axis. According to embodiments, this profile forming is achieved by shaping the phase distribution of the laser beam 50 as it will be described in more detail below.

A flat top profile is ideally constant in the main portion around a central line of the beam and drops sharply only at the beam edges. In a front view it may look like a sharp circle whereas a Gaussian-like profile looks like a blurry circle.

The steering elements 130 are configured to steer the laser beam 50 towards the profile forming component 120 or to direct the laser beam 50 towards the fusion fuel pellet 10 after the profile forming component 120 to trigger the fusion reaction by the laser beam 50.

Compared to the Gaussian-like profile utilized in embodiments, a flat (or nearly flat) beam profile illuminating the entire DT capsule (fusion fuel pellet 10) may have some advantages for inertial confinement fusion experiments. For example, although flat profiles show fewer pointing errors and beam-to-beam power balance errors due to the fact that many beams are overlapping one another on the surface of the DT capsule, a flat profile provides only a low energy coupling from the laser to the DT capsule.

On the one hand, the laser beam profile according to embodiments provide the desired irradiation uniformity to further reduce the total number of required laser beams. The inventors have reached this conclusion by various investigations to find an optimum laser beam spatial profile. The novel beam profile shape produces highly uniform irradiation patterns - even when small laser beam spot radii are used.

A mathematical proof of the efficacy of Gaussian-like beams 57 will be given below. Various beam profiles have been considered including Gaussian profiles, Airy profiles, $\cos^{\beta}$ (theta) profiles, Cauchy profiles, and other profiles with a singular peak at the center and decreasing intensity moving away from the central peak. It turned out that the Gaussian-like beams maintain their smooth irradiation even when the beam spot radius is smaller than the capsule radius. Smaller beam spot radii provide the advantage of improving laser energy coupling to the DT capsule 10 for a number of reasons. It reduces the amount of laser light that is scattered away from the capsule because fewer light rays approach the capsule 10 with an oblique incidence. There is also less beam-to-beam overlap which means there will be less cross beam energy transfer. And, a smaller beam spot radius means less laser energy will blow by the target; which happens as the DT capsule 10 shrinks due to compression and the laser beam radius is larger than the capsule radius.

A possible counterargument to the validity of using Gaussian-like beams with small beam spot radius relative to the capsule is beam-to-beam power balance. With less overlapping beams at each point on the capsule, the irradiation uniformity will be more susceptible to the natural shot-to-shot variation in beam power for each beam. To remedy this, optional embodiments provide multiple beams 50 within each port of the target chamber to minimize beam-to-beam power balance issues. However, embodiments should not be limited to multiple beams. Multiple beams may provide the mentioned advantages, but the inventive concept does not require them for overcoming at least some of the drawbacks of conventional systems.

To produce the beam shape at the fuel capsule (fusion fuel pellet 10), embodiments utilize a number of hardware components. The laser beam will be generated by a laser source that may include an amplifier beamline to amplify the laser (and possibly split into multiple beams). The laser beam 50 coming from the amplifier chain typically has a spatial intensity profile which is nearly "flat-top" in shape or can be described by a "Super-Gaussian" profile. Embodiments may use as hardware elements to control the beam profile 57 on the fusion fuel pellet 10 one or more of the following:

(i) optics that modify the wavefront, or phase, of the beam,
(ii) optics that focus the beam to a small spot size.

Hardware in the first category (i) may include deformable mirrors and/or phase plates. A deformable mirror is an active optic made up of an array of actuators attached to a reflective membrane. The height of the mirror surface can be varied to change the path length traveled by regions of the beam, changing the relative phase. Phase plates are static optics made, e.g., of transmissive material like fused silica or BK-7 glass with varying thickness. Deformable mirrors can have upwards of fifty actuators while phase plates can be designed with custom resolution that is typically finer than a deformable mirror. However, phase plates in general cannot be changed once manufactured. The most common use of phase plates is to create final intensity profiles that are uniform or flat-top at the fusion fuel capsule 10.

The second category (ii) of hardware may include focusing optics that are either reflective or transmissive and differ minimally in the result.

Utilizing the combinations of the above hardware, embodiments involve producing beams with Gaussian-like intensity profiles 57 with a diameter that can be given by a width where the intensity profile has dropped by appropriately $e^{-2}$ (e is the Euler number) or based on the inflection points of the Gaussian-like intensity profiles 57. As will be described with the next figures, various embodiments produce the desired beam profile shapes using a laser beam transport setup that includes the use of deformable mirrors and/or phase plates to dynamically produce the beam profile 57 for a given inertial confinement fusion experiment.

**Fig. 2** illustrates an embodiment for the irradiation assembly 100, wherein the laser beam 50 from an amplifier comprises a near flat top intensity spatial profile 52. The incoming laser beam 50 may comprise an initial phase distribution 51 that is nonuniform (e.g. an aberrated wave front profile) which is generated by the laser amplifier or laser source 60 which will enter the irradiation assembly 100 through the optical input 110. In the embodiments of Fig. 2, the profile forming component 120 includes a deformable mirror 122 and focusing lens 126. Furthermore, the assembly includes as steering element 130 a steering mirror.

During operation, the incoming laser beam 50 is received by a steering mirror 130 and, thereafter, by the deformable mirror 122. The deformable mirror 122 is adapted to generate a corrected phase distribution 53 (e.g. a shaped phase front profile for Gaussian-like focus) which after it passes the focusing lens 126 will propagate towards the fusion fuel pellet 10. The focusing lens 126 and the profile forming component 120 are adapted to generate the final Gaussian-like intensity profile 57 of the laser beam 50 with an adjusted (correct) size at the surface of the fusion fuel pellet 10.

For this, the deformable mirror 122 only modifies the initial phase distribution 51 so that the final Gaussian-like intensity profile 57 occurs at the fusion fuel pellet 10. Therefore, the initial transverse intensity profile 52 and the shaped wave front profile 53 formed by the deformable mirror 120 (before passing the focusing lens 126) do not have a Gaussian-like profile. However, the final Gaussian-like intensity profile 57 will show up close to or at the fusion fuel pellet 10.

In other word, in the depicted embodiment, a laser beam 50 from a main amplifier chain is transported to the final optics assembly at the optical input of the final beam transport. After amplification, the laser beam 50 is directed to the surface of a deformable mirror 122, then propagates through a focusing lens 126 to the fusion fuel pellet 10. The deformable mirror surface profile is chosen to both compensate for the wave front aberration imparted by the amplifying laser chain and impart an additional spatial phase profile that will result in a Gaussian-like profile 57 at the target 10. The deformable mirror 122 may include a large number of actuators 123 (e.g. more than 10 or more than 50 or between 30 and 60 actuators) which vary the height of the mirror surface.

The embodiment of Fig. 2 further includes an adjacent laser beam 250 (e.g. compression laser beams) which is formed by another irradiation assembly along another angular direction when viewed from the fusion fuel pellet 10. For example, the adjacent laser beam 250 can be formed in such a way that on the surface of the fusion fuel pellet 10 the Gaussian-like profiles 57 of the irradiated laser beams 50 will overlap to a certain extent in order to uniformly irradiate the surface of the fusion fuel pellet 10. The adjacent irradiation assembly 250 may have the same components as the ones described before. Only a focusing lens 226 is shown in Fig. 2 and all other components are omitted.

It is understood that in addition to these two irradiation assemblies there may be more irradiation assemblies so that the fusion fuel pellet 10 will be irradiated by laser beams 50 from possibly all directions so that ideally the complete surface of the fusion fuel pellet 10 will be subject to a laser beam irradiation in order to ensure a uniform heating and pressure application from all directions. Therefore, the embodiment of Fig. 2 also covers an irradiation system 200 with multiple irradiation assemblies 100 as described before.

**Fig. 3** illustrates yet another embodiment of the irradiation assembly 100. When compared to the embodiment of Fig. 2, the profile forming component 120 includes a phase plate 124, which is arranged between the deformable mirror 122 and the focusing lens 126. In this embodiment, the deformable mirror 122 is adapted to transform the initial phase distribution 51 of the incoming laser beam 50 that has aberrations, or nonuniformities, (from the amplifier) into a corrected flat wave front 55 that propagates from the deformable mirror 122 towards the phase plate 124. The phase plate 124 is adapted to transform the corrected flat wave front 55 into a shaped phase front profile 53 which is configured to produce a Gaussian-like intensity profile 57 at the fusion fuel pellet 10. Again, the laser beam 50 propagates from the phase plate 124 to the focusing lens 126 and, thereafter, will be shaped as the Gaussian-like profile 57 when arriving at the fusion fuel pellet 10.

The phase plate 124 may be designed from a transmissive material (such as fused silica or borosilicate crown glass; BK-7 glass) with varying thickness throughout the aperture of the plate. The thickness profile may be chosen during manufacturing to impart a spatial wave front distribution that results in a Gaussian-like intensity profile at the fusion fuel pellet 10 after transit of the lens 126. For this, the phase plate 124 may be formed in such a way that the laser beam 50 that passes through the phase plate is subject to a phase shift, wherein the phase shift depends on the position on the phase plate 124. This may be achieved by different thicknesses of the phase plate resulting in different optical distance for the laser beam 50 when passing through the phase plate.

The different phase shifts may result in an effective steering of laser intensities in a desired direction. However, in order to ensure a Gaussian profile at the fusion fuel pellet 10, the phase plate 124 shall not act as focusing lens, but ensures only that at a given moment in time, the beam intensity at the phase plate 124 exhibits the spatial Gaussian-like profile 57. For this, the phase plate 124 may formed with pattern of thickened regions (surface portions) over the phase plate 124 that ensure the desired Gaussian-like profile 57 at the fusion fuel pellet 10. The pattern may be regular or irregular and can be adjusted according to the needs.

It is also possible that the phase plate 124 is formed by a plurality of concentric rings (of different widths), wherein starting from the position at the center line 54, adjacent rings will provide different optical thicknesses for the respective laser light components traveling through these rings. As a result, although the laser beam 50 is still rotationally symmetric around the central line 54, an amount of phase shifts can be adjusted as needed (as function of the radius).

As set out before, the same effect can be achieved by the deformable mirrors 122 which deforms the reflective surface 125 by a plurality of actuators 123 so that the optical distances for respective portions of the laser beams 50 are different, resulting in a phase shift depending on the position of the reflection point on the deformable mirror 122.

The deformable mirror 122 of this embodiment maybe utilized to correct residual spatial phase aberrations imparted from the amplifier chain before the wave front 55 propagates through a phase plate 124. The deformable mirror 122 may also be used to change the focus during operation (e.g. from one laser pulse to the next laser pulse).

**Fig. 4** illustrates yet another embodiment for the irradiation assembly 100, wherein, when compared to the embodiment of Fig. 2, the steering mirror 130 is replaced by another deformable mirror 122a. Therefore, the embodiment of Fig. 4 comprises two deformable mirrors 122a, 122b, wherein a first deformable mirror 122a is arranged to receive the laser beam 50 from the laser source 60 (or amplifier). This laser beam 50 may again have an aberrated wave front profile 51 and the first deformable mirror 122a may be adapted to transform the aberrated wave front profile 51 into a corrected flat wave front 55 that propagates from the first deformable mirror 122a towards the second deformable mirror 122b. The second deformable mirror 122b maybe adapted to transform the corrected flat wave front 55 into a shaped phase front profile 53 that upon being focused by the focusing lens 126 will arrive at the fusion fuel pellet 10 with a Gaussian-like profile 57.

Therefore, the first deformable mirror 122a may remove residual spatial phase aberrations on the incoming beam 50 and the second deformable mirror 122b may impart a phase needed to bring the laser beam 50 to a Gaussian-like profile 57 after transit of the lens 126.

**Fig. 5** illustrates yet another embodiment which, when compared to the embodiment as shown in Fig. 4, comprises instead of the focusing lens 126 and the second deformable mirror 122b a focusing mirror 128. In this embodiment, the deformable mirror 122 is adapted to transform the aberrated wave front profile 51 into the shaped phase front profile 53 that propagates from the deformable mirror 122 towards the focusing mirror 128. After being reflected at the focusing mirror 128 the laser beam 50 propagates to the fusion fuel pellet 10. Again, the Gaussian-like profile 57 may only emerge (from the shaped phase front profile 53) at the fusion fuel pellet 10. Therefore, in this embodiment the focusing lens is replaced with a curved mirror 128 to serve as focusing optic.

All four techniques described with Figs. 2 to 5 are appropriate for the realization of the inventive concept. These designs are examples of hardware combinations that can produce the desired Gaussian-like profiles at the target 10. It is understood that other combinations may produce the same desired effect, including two deformable mirrors 122, one phase plate 124 and a lens 126, or two deformable mirrors 122, one phase plate 124 and a focusing mirror 128 among others. Embodiments utilize deformable mirrors 122, phase plates 124 and focusing optics 126, 128 as possible realizations of the profile forming component 120 to produce Gaussian-like beam profiles 57 at the fusion fuel pellet 10.

**Fig. 6** shows a schematic flow chart for a method for triggering a laser-based fusion reaction in a fusion fuel pellet. The method comprises:

- providing S110 a laser beam 50 originating from a laser source 60 with an initial transverse phase distribution 51 and intensity profile 52;
- transforming S120 the initial transverse intensity profile 52 into a final transverse intensity profile at the pellet 57 by shaping the initial phase distribution 51; and
- steering S130 the laser beam 50 towards the profile forming component or towards the fusion fuel pellet 10 to trigger the fusion reaction in the fusion fuel pellet 10 by the laser beam 50 with the Gaussian-like profile 57.

It is understood that the method may include further steps. In addition, the order of the step may be different. For example, all functions described before in conjunction with the irradiation assembly maybe, according to further embodiments, realized as further optional method steps.

The following shall show, mathematically, the validity of embodiments, namely that a Gaussian-like beam profile may produce a more uniform irradiation pattern than Super-Gaussian or other beam profiles over a wider range of potential beam configurations. As a consequence, one can leverage the enhanced uniformity by reducing the beam spot size which increases energy coupling to the fusion fuel pellet 10 and reduces laser-matter instabilities that can arise using larger beam spot radii which can quench a fusion reaction.

The mathematical formalism for proving begins with identifying the relevant equations involved. There are two conventional beam profiles which we will compare to the first-order Gaussian ($G_1$) beam profile. The first is the beam profile given by the fourth order Super-Gaussian $G_4$ and the second is the cosine profile $C_1$. The functional form for the spatial intensity profile of the Gaussian, the $4^{th}$-order super-Gaussian, and the cosine, as a function of position is shown in equations

$$G_1(x) = e^{-2\frac{(x-\mu)^2}{\sigma^2}} \tag{1}$$

$$G_4(x) = e^{-2\left(\frac{(x-\mu)^2}{\sigma^2}\right)^4} \tag{2}$$

$$C_1(x) = \cos\left(\arccos\left(e^{-2}\right)\frac{(x-\mu)}{\sigma}\right) \tag{3}$$

Where x is the position, $\mu$ is the mean or central point of the profile, and $\sigma$ is the radius of the beam. All beam profiles have been defined such that the radius, $\sigma$, corresponds to the position where the magnitude of the beam intensity has been reduced by a factor of $e_2$, the traditional definition within the laser physics community. If a train of beams for each profile is considered, spaced apart along x by a distance d, where each beam has a central point located in x at point n*d, where n is integers over all x, the equation for the total intensity (sum of all contributions) of that train of beams for $G_1^{tot}$, $G_4^{tot}$, and $C_1^{tot}$ respectively would be:

$$G_1^{tot}(x) = \sum_{n=-\infty}^{\infty} e^{-2\frac{(x-nd)^2}{\sigma^2}} \tag{4}$$

$$G_4^{tot}(x) = \sum_{n=-\infty}^{\infty} e^{-2\left(\frac{(x-nd)^2}{\sigma^2}\right)^4}$$

$$\tag{5}$$

$$C_1^{tot}(x) = \sum_{n=-\infty}^{\infty} \cos\left(\arccos\left(e^{-2}\right)\frac{(x-nd)}{\sigma}\right)$$

$$\tag{6}$$

**Fig. 7** depicts single beam intensity profiles for the $G_1$ (top left), $G_4$ (top middle) and $C_1$ (top right) distributions wherein the peak intensity is normalized to one. The bottom row shows a train of beams spaced a distance, d, apart from each other for the same distributions, $G_1$ (bottom left), $G_4$ (bottom middle) and $C_1$ (bottom right). The distance d may be given by the radius $\sigma$ or a multiple (2* $\sigma$, 3* $\sigma$ etc.) or a fraction thereof ($\sigma$/2 or ($\sigma$/3 etc.). The plots correspond to equations (1) to (6) where the top row shows individual beam profiles: plot 710 for eq. (1), plot 720 for eq. (2), and plot 730 for eq. (3), wherein the radius is one ($\sigma$=1), and centered at x=0. The bottom row shows the train of pulses along with the sum of the train (thick black) defined by equations (4) to (6), i.e. a plot 715 for eq. (4), a plot 725 for eq. (5), and a plot 735 for eq. (6). These trains of equally spaced pulses are simplified to one-dimensional planar geometry.

The sum of each train already illustrates the benefit of a Gaussian beam ($G_1$) over a fourth-order Super-Gaussian ($G_4$) or Cosine ($C_1$) beam wherein the sum deviates minimally from the normalized maximum value of one.

**Fig. 8** illustrates the irradiation nonuniformity (rms) as a function of the periodic spacing between each beam for $G_1^{tot}$ (plot 810) $G_4^{tot}$ (plot 820), and $C_1^{tot}$ (plot 830). There is a comparatively dramatic drop in irradiation nonuniformity of plot 810 (beam train $G_1^{tot}$), 9 billion times more uniform than the other two profiles when the spacing is 0.4 times the beam radius.

These plots illustrate how the irradiation non-uniformity (rms) of the trains depend on the different beam profiles, and, how the irradiation nonuniformity changes as the spacing between the beams, d, changes. It turns out to be straightforward (e.g. using Fourier Transforms) to decompose the profile into its frequency components. The amplitude of each frequency component, when added together in quadrature, quantifies the variation in magnitude of the given profile and is equal to the standard deviation of the profile.

To calculate the Fourier Transform of the train of Gaussian profiles $G_1$, one may first recall that the Fourier Transform of any function, f(x, $\mu$=n*d) that repeats itself periodically in space is just the Fourier Convolution of a single function, f(x, $\mu$=0) centered at x=0 with the Dirac Comb (an infinite series of Dirac delta functions spaced in x a distance, d, apart), which can be seen in the follow equation for the Fourier Transform:

$$\mathcal{F}\left\{G_1^{tot}\right\} = \mathcal{F}\left\{\sum_{n=-\infty}^{\infty} e^{-2\frac{(x-nd)^2}{\sigma^2}}\right\} = \mathcal{F}\left\{e^{-2\frac{x^2}{\sigma^2}} * \mathrm{III}_d(x)\right\} = \mathcal{F}\left\{e^{-2\frac{x^2}{\sigma^2}}\right\}\mathcal{F}\left\{\mathrm{III}_d(x)\right\}$$

$$\tag{7}$$

where $\mathrm{III}_d$ is the Dirac Comb (the subscript, d, defines the period of the delta-functions). This drastically simplifies the problem because the Fourier Transform of these single beam profile functions centered at x=0, and the Fourier Transform of the Dirac Comb are well known. The Fourier Transform of the Dirac Comb with period, d, is just a Dirac Comb with period 1/d. The Fourier Transform of a Gaussian profile with radius, $\sigma$, is also a Gaussian profile, but with radius, 1/$\sigma$. The amplitude of the variation of $G_1^{tot}$ is then the quadrature sum of the amplitude of a Gaussian profile with radius, 1/$\sigma$, at points, n/d, for integer values of n. What this means (and the key finding of the inventors) is that the irradiation nonuniformity reduces dramatically ($\sim e^{-(1/d)^2}$) as the spacing between the beams is reduced. This can be seen in Fig. 8 indicating that for plot 810, the nonuniformity reduces much faster than for any other beam profile.

The other two conventional profiles (plot 820, plot 830) have more complicated Fourier Transforms (analytically complex but numerically simple), but are shown in Fig. 8. As can be seen in Fig. 8, the Gaussian beam's irradiation uniformity is roughly 9 orders of magnitude better than the other two distributions $G_4^{tot}$ (plot 820), and $C_1^{tot}$ (plot 830), when the beam spacing is 0.4 times the beam radius.

This Fourier analysis shows that Gaussian beams, and more broadly, any profile generally resembling a Gaussian profile (i.e. Gaussian-like beams) are superior over other profiles like "flat-top" Super-Gaussian beams. Gaussian-like profiles can include Airy profiles, $\cos^n$ profiles, and Cauchy profiles to name a few. The primary requirement is that the profile has a peak at a singular point in x, followed by generally decreasing amplitude moving away from the peak in x.

The description and drawings merely illustrate the principles of the disclosure. It will thus be appreciated that those skilled in the art will be able to devise various arrangements that, although not explicitly described or shown herein, embody the principles of the disclosure and are included within its scope.

Furthermore, while each embodiment may stand on its own as a separate example, it is to be noted that in other embodiments the defined features can be combined differently, i.e. a particular feature described in one embodiment may also be realized in other embodiments. Such combinations are covered by the disclosure herein unless it is stated that a specific combination is not intended.

Although the invention has been illustrated and described in detail by way of preferred embodiments, the invention is not limited by the examples disclosed, and other variations can be derived from these by the person skilled in the art without leaving the scope of the invention. It is therefore clear that there is a plurality of possible variations. It is also clear that embodiments stated by way of example are only really examples that are not to be seen as limiting the scope, application possibilities or configuration of the invention in any way. In fact, the preceding description and the description of the figures enable the person skilled in the art to implement the exemplary embodiments in concrete manner, wherein, with the knowledge of the disclosed inventive concept, the person skilled in the art is able to undertake various changes, for example, with regard to the functioning or arrangement of individual elements stated in an exemplary embodiment without leaving the scope of the invention, which is defined by the claims and their legal equivalents, such as further explanations in the description.

List of reference signs

| 10 | fusion fuel pellet(s) |
|---|---|
| 50 | laser beam |
| 51 | initial transverse phase distribution |
| 52 | initial transverse intensity profile |
| 53 | transformed/shaped phase distribution |
| 54 | center line of laser beam (optical axis) |
| 55 | aberration corrected wave front |
| 57 | final Gaussian-like transverse intensity profile |
| 60 | laser source |
| 100 | irradiation assembly for a laser-based fusion reaction |
| 110 | optical input |
| 120 | profile forming component |
| 122 | deformable mirror(s) |
| 123 | actuators of deformable mirror(s) |
| 125 | reflective surface |
| 124 | phase plate(s) |
| 126 | focusing lens(es) |
| 128 | focusing mirror(s) |
| 130 | steering element(s) |
| 200 | irradiation systems comprised of multiple irradiation assemblies |
| 226 | optical component of adjacent irradiation assembly |
| 250 | laser beam of adjacent irradiation assembly |
| 710, 720, 730 | different spatial profiles |
| 715, 725, 735 | normalized laser intensity for different spatial profiles |
| 810, 820, 830 | irradiation nonuniformity of different spatial profiles |

**Claims**

1. An irradiation assembly (100) for a laser-based fusion reaction, the laser-based fusion reaction being an initiation of a fusion reaction in a fusion fuel pellet (10) by a laser beam (50), the irradiation assembly (100) comprising:

- an optical input (110) for the laser beam (50) originating from a laser source (60), the laser beam (50) having an initial transverse phase distribution (51) and an initial transverse intensity profile (52);

- a profile forming component (120) configured to shape the initial phase distribution (51) of the laser beam (50) so that the initial transverse intensity profile (52) is transformed into a final transverse intensity profile (57) at the fusion fuel pellet (10); and
- at least one steering element (130) configured to steer the laser beam (50) towards the profile forming component (120) or towards the fusion fuel pellet (10) to trigger the fusion reaction in the fusion fuel pellet (10) by the laser beam (50),

wherein the final transverse intensity profile (57) has a Gaussian-like profile when arriving at the fusion fuel pellet (10).

2. The irradiation assembly (100) according to claim 1, wherein the profile forming component (120) includes at least one of the following:

- one or more deformable mirrors (122) with a locally deformable reflective surface configured to shape the initial phase distribution (51) of the laser beam (50);
- one or more phase plates (124) with variable thickness configured to shape the initial phase distribution (51) of the laser beam (50);
- one or more deformable phase plates configured to shape the initial phase distribution (51) of the laser beam (50);
- one or more focusing lenses (126) to focus the laser beam (50) to the fusion fuel pellet (10);
- one or more focusing mirrors (128) to focus the laser beam (50) to the fusion fuel pellet (10).

3. The irradiation assembly (100) according to claim 2, wherein the one or more deformable mirrors (122) include at least one actuator (123) configured to locally shift the reflection surface.

4. The irradiation assembly (100) according to claim 2 or claim 3, wherein the one or more phase plates (124) include a transparent substrate with a pattern of transparent layers formed on a surface to provide a pattern of different optical distances for the laser beam (50) upon passing through the phase plates (124).

5. The irradiation assembly (100) according to any one of claims 1 to 4, wherein the profile forming component (120) is configured to shape the initial phase distribution (51) to produce the final transverse intensity profile (57) that is Gaussian-like with a predetermined size of at most a size of the fusion fuel pellet (10) when hitting the fusion fuel pellet (10).

6. The irradiation assembly (100) according to any one of claims 1 to 5, the assembly (100) further comprising a control device configured to optimize the final transverse intensity profile (57) by controlling, during operation, at least one of the following:

the profile forming component (120) to shape the initial phase distribution (51) of the laser beam (50),
the at least one steering element (130) to steer the laser beam (50).

7. The irradiation assembly (100) according to any one of claims 1 to 6, further including:

- a laser amplifier configured to amplify the laser beam (50) with a near flattop spatial profile (52) and to provide the laser beam (50) at the optical input (110).

8. An irradiation system (200) comprising multiple irradiation assemblies (100) according to any one of claims 1 to 7 which are arranged to irradiate the fusion fuel pellet (10) from different directions with respective laser beams (50).

9. The irradiation system (200) according to claim 8, wherein each irradiation assembly (100) directs a laser beam (50) onto a respective surface portion of the fusion fuel pellet (10), wherein the surface portions have some degree of overlap with each other.

10. The irradiation system (200) according to claim 8 or claim 9, wherein the fusion fuel pellet (10) is positioned at the center of a target chamber with multiple ports for the multiple laser beams (50), the multiple irradiation assemblies (100) are arranged to provide the multiple laser beams (50) through at least one of the multiple ports.

11. A method for triggering a laser-based fusion reaction in a fusion fuel pellet (10), the method comprising:

- providing (S110) a laser beam (50) originating from a laser source (60) with an initial transverse phase distribution (51) and intensity profile (52);
- transforming (S120) the initial transverse intensity profile (52) into a final transverse profile (57) at the fusion fuel pellet (10) by shaping the initial phase distribution (51) of the laser beam (50); and
- steering (S130) the laser beam (50) towards a profile forming component (120) or towards the fusion fuel pellet (10) to trigger the fusion reaction in the fusion fuel pellet (10) by the laser beam (50),

wherein the final transverse intensity profile (57) has a Gaussian-like profile when arriving at the fusion fuel pellet (10).

12. The method of claim 11, wherein the step of transforming the initial transverse intensity profile (52) into the final Gaussian-like transverse intensity profile (57) includes modifying the initial phase distribution (51) into a shaped phase distribution (53) by one or more of the following:

- reflecting the laser beam (50) at a non-homogenous surface;
- refracting the laser beam (50) by a focusing lens or an adaptive lens;
- adaptively shifting phases of the laser beam (50) in a cross section of the laser beam (50).

Fig. 1

Fig. 2

EP 4 376 023 A1

Fig. 3

EP 4 376 023 A1

Fig. 4

Fig. 5

providing a laser beam with an
initial transverse phase distribution
and intensity profile

S110

transforming the initial transverse
intensity profile into a final
transverse profile

S120

steering the laser beam to trigger
the fusion reaction in the fusion
fuel pellet by a laser beam with
a Gaussian-like profile

S130

Fig. 6

Single Gaussian Beam 710

Single 4th-Order Super Gaussian Beam 720

Single Cosine Beam 730

Train of Gaussian Beams 715 710

Train of 4th-Order Super Gaussian Beam 725 720

Train of Cosine Beams 735 730

Fig. 7

EP 4 376 023 A1

Fig. 8

EP 4 376 023 A1

Europäisches
Patentamt

European
Patent Office

Office européen
des brevets

# EUROPEAN SEARCH REPORT

**Application Number**

EP 23 21 1162

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LEHMBERG R H ET AL: "USE OF INCOHERENCE TO PRODUCE SMOOTH AND CONTROLLABLE IRRADIATION PROFILES WITH KRF FUSION LASERS", FUSION TECHNOLOGY, AMERICAN NUCLEAR SOCIETY. LAGRANGE PARK, ILLINOIS, US, vol. 11, no. 3, 1 May 1987 (1987-05-01), pages 532-541, XP000709879, ISSN: 0748-1896 | 1,5,11 | INV. G21B1/23 H01S3/00 |
| Y | * abstract * * page 7, column 2, line 17 - page 9, column 1, line 22; figures 1, 2 * | 2-4, 6-10,12 | |
| Y | US 2011/147616 A1 (BEAUREPAIRE EMMANUEL JEAN-MARC [FR] ET AL) 23 June 2011 (2011-06-23) * paragraphs [0021], [0057]; figure 4 * | 2-4,6,12 | |
| Y | LUCE JACQUES ED - FORBES ANDREW ET AL: "Beam shaping in the MegaJoule laser project", LASER BEAM SHAPING XII, SPIE, 1000 20TH ST. BELLINGHAM WA 98225-6705 USA, vol. 8130, no. 1, 8 September 2011 (2011-09-08), pages 1-6, XP060018738, DOI: 10.1117/12.895931 [retrieved on 1901-01-01] | 7 | |
| A | * the whole document * | 2-4,12 | |
| Y | US 2014/044226 A1 (CAMPBELL E MICHAEL [US] ET AL) 13 February 2014 (2014-02-13) * paragraph [0143]; figure 3 * | 8-10 | |

**TECHNICAL FIELDS SEARCHED (IPC)**

G01N
G21B
H01S

The present search report has been drawn up for all claims

| Place of search | Date of completion of the search | Examiner |
|---|---|---|
| Munich | 8 March 2024 | Sewtz, Michael |

EPO FORM 1503 03.82 (P04C01)

## ANNEX TO THE EUROPEAN SEARCH REPORT
## ON EUROPEAN PATENT APPLICATION NO.

EP 23 21 1162

This annex lists the patent family members relating to the patent documents cited in the above-mentioned European search report.
The members are as contained in the European Patent Office EDP file on
The European Patent Office is in no way liable for these particulars which are merely given for the purpose of information.

08-03-2024

| Patent document cited in search report | | Publication date | Patent family member(s) | | Publication date |
|---|---|---|---|---|---|
| US 2011147616 | A1 | 23-06-2011 | EP | 2304488 A2 | 06-04-2011 |
| | | | FR | 2933209 A1 | 01-01-2010 |
| | | | JP | 5453407 B2 | 26-03-2014 |
| | | | JP | 2011526001 A | 29-09-2011 |
| | | | US | 2011147616 A1 | 23-06-2011 |
| | | | WO | 2009156702 A2 | 30-12-2009 |
| US 2014044226 | A1 | 13-02-2014 | EP | 2700288 A1 | 26-02-2014 |
| | | | US | 2014044226 A1 | 13-02-2014 |
| | | | US | 2021120656 A1 | 22-04-2021 |
| | | | US | 2024015877 A1 | 11-01-2024 |
| | | | WO | 2012145534 A1 | 26-10-2012 |

EPO FORM P0459

For more details about this annex : see Official Journal of the European Patent Office, No. 12/82